# EUROPEAN PATENT APPLICATION

(11) **EP 4 439 661 A1**
(43) Date of publication of application: **02.10.2024**
(21) Application number: 24166465.5
(22) Date of filing: 26.03.2024
(51) Int. Cl.: H01L 23/498, H01L 23/538, H01L 23/00

(54) **METHOD OF MANUFACTURING SEMICONDUCTOR DEVICES AND CORRESPONDING SEMICONDUCTOR DEVICE**

(30) Priority: 29.03.2023 IT 202300006129
(71) Applicant: STMicroelectronics International N.V., 1228 Plan-les-Ouates, Geneva (CH)
(72) Inventor: CATALANO, Guendalina, I-20125 Milano (IT); BELLIZZI, Antonio, I-20093 Cologno Monzese (Milano) (IT); ZAFFERONI, Claudio, I-20871 Vimercate (Monza Brianza) (IT)
(74) Representative: Buzzi, Notaro & Antonielli d'Oulx S.p.A.

(57) **Abstract**

Laser direct structuring, LDS material (20) is molded onto a semiconductor chip (14) arranged on a, possibly sacrificial, substrate (S) with a first surface facing away from the substrate (S) and one or more adjacent electrically conductive formations (12B) arranged on the substrate (S), wherein the LDS material (20) has a first thickness (T1) between a front surface of the LDS material (20) and the substrate (S). The first surface of the semiconductor chip (14) and the electrically conductive formation (12B) are electrically coupled (181, 182, 183) with electrically conductive material grown in one or more vias (183) laser structured in the LDS material (20).

Unstructured LDS material is removed (with a blade, for instance) from the front surface of the LDS material (20) to form therein a cavity (100) having an end wall (100A) between the front surface of the LDS material (20) and the electrically conductive formation(s) (12B). At the cavity (100), the LDS material has a second thickness (T2) smaller than said first thickness (T1). Laser beam energy (LB) is applied to the LDS material (20) at the end wall (100A) of the cavity (100) to structure therein one or more vias (183) that extends between the end wall (100A) of the cavity (100) and the electrically conductive formation(s) (12B).

## Description

### Technical field

The description relates to manufacturing semiconductor devices.

Solutions as described herein can be applied to Quad Flat No-Leads packages for integrated circuit (IC) semiconductor devices for automotive or industrial application, for instance.

### Background

In packages such as Quad Flat No-leads (QFN) packages, interconnections may be provided via laser direct structuring, LDS.

LDS is based on laser ablation of a molding compound having additive particles embedded therein and that are activated during laser ablation. Activated particles facilitate subsequent plating steps that form electrically conductive interconnections as desired.

In certain QFN packages, comprising, for instance, a relatively thick die or two (or more) stacked dice, some interconnections may end up by being located deep inside the molding compound to provide a desired coupling and such deep interconnects (such as deep vias, for instance) may give rise to design and plating issues.

In fact, laser machining cannot drill "vertically" through a molding compound and through-mold-vias (TMVs) are rather formed with a conical shape. To adequately plate such a conical TMV the diameter of the via at the base of the conical shape should be approximately equal to the depth of the via (1:1 aspect ratio).

For deep interconnects such a design rule may pose constraints in so far as vias may not fit with package dimensions.

Documents 2019/115287 A1, US 2021/305203 A1, and 2021/183748 A1 (further cited in the following) are exemplary of background art.

EP 4 181 177 A1 is a document according to Art. 54(3) EPC exemplary of related art.

### Object and summary

Solutions as described herein aim at addressing the issues discussed in the foregoing.

Such an object can be achieved via a method having the features set forth in the claims that follow.

One or more embodiments relate to a corresponding (integrated circuit) semiconductor device.

The claims are an integral part of the technical teaching provided in respect of the embodiments.

Solutions as described herein provide a time- and cost- effective method of forming electrically conductive through-mold-vias via laser direct structuring, LDS.

Solutions as described herein facilitate manufacturing semiconductor devices comprising thick or stacked dice.

Solutions as described herein may be used to form die-to-lead as well as die-to-die interconnects.

In solutions as described herein, the thickness of the (LDS) molding compound that is laser drilled is reduced by removing a portion of molding compound prior to drilling.

Solutions as described herein are compatible with concurrent processing of a plurality of semiconductor devices.

### Brief description of the several views of the drawings

One or more embodiments will now be described, by way of example only, with reference to the annexed figures, wherein:
Figure 1 is a cross-sectional view exemplary of the structure of a semiconductor device;
Figures 2A and 2B are cross-sectional views of portions of semiconductor devices showing possible constraints that may arise in manufacturing such devices;
Figures 3A to 3E are cross-sectional views illustrating processing steps according to an embodiment of the present description;
Figures 4A to 4D are cross-sectional views illustrating processing steps according to embodiments of the present description;
Figure 5 is a cross-sectional view illustrating another embodiment of the present description; and
Figures 6A and 6B are plan views illustrating concurrent processing of a plurality of semiconductor devices according to embodiments of the present description.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular conformations, structures, or characteristics may be combined in any adequate way in one or more embodiments.

The headings/references used herein are provided merely for convenience and hence do not define the extent of protection or the scope of the embodiments.

For simplicity and ease of explanation, throughout this description, and unless the context indicates otherwise, like parts or elements are indicated in the various figures with like reference signs, and a corresponding description will not be repeated for each and every figure.

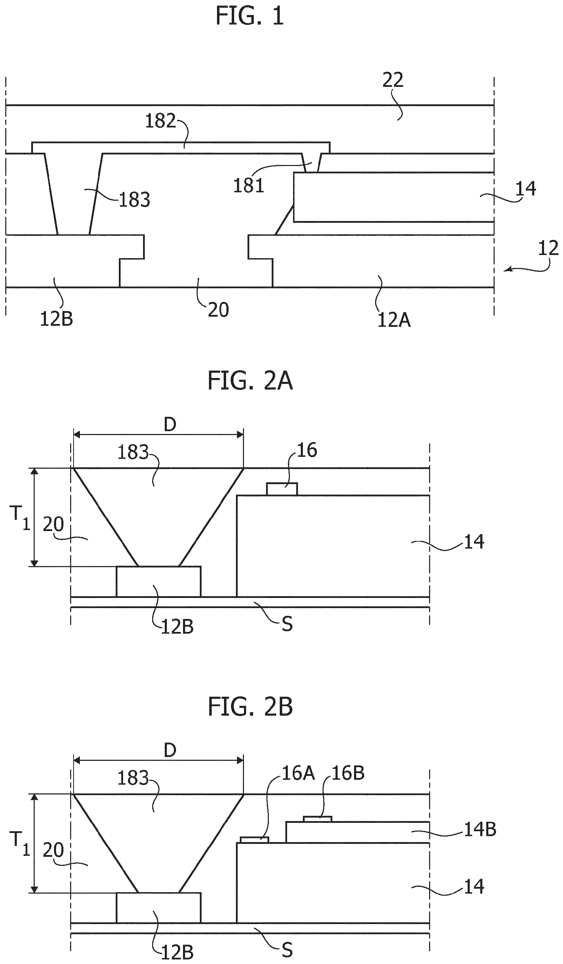

Figure 1 is illustrative of interconnects formed in an (integrated circuit) semiconductor device via laser direct structuring, LDS.

Laser direct structuring is a laser-based machining technique now widely used in various sectors of the industrial and consumer electronics markets, for instance for high-performance antenna integration, where an antenna design can be directly formed onto a molded plastic part.

In an exemplary process, the molded parts can be produced with commercially available insulating resins that include additives suitable for the LDS process; a broad range of resins such as polymer resins like PC, PC/ABS, ABS, LCP are currently available for that purpose.

In LDS, a laser beam can be used to transfer ("structure") a desired electrically-conductive pattern onto a plastic molding that may then be subjected to metallization to finalize a desired conductive pattern.

Metallization (with copper, for instance) may involve electroless plating followed by electrolytic plating.

Electroless plating, also known as chemical plating, is a class of industrial chemical processes that creates metal coatings on various materials by autocatalytic chemical reduction of metal cations in a liquid bath.

In electrolytic plating, an electric field between an anode and a workpiece, acting as a cathode, forces positively charged metal ions to move to the cathode where they give up their charge and deposit as metal on the surface of the work piece.

Documents such as US 2018/342453 A1, US2019/115287 A1, US 2020/203264 A1, US 2020/321274 A1, US 2021/050226 A1, US 2021/050299 A1, US 2021/183748 A1, or US 2021/305203 A1 (all assigned to the same assignee of the present application) are exemplary of the possibility of applying LDS technology in manufacturing semiconductor devices.

Figure 1 illustrates a portion of an integrated circuit (IC) semiconductor device comprising:
a substrate 12, such as a leadframe, including a die mounting location or die pad 12A and a plurality of leads 12B,
a (integrated circuit) semiconductor (silicon, for instance) die or chip 14 mounted on a die mounting location, such as a die pad 12A,
an insulating encapsulation 20, 22 providing a protective plastic package for the device, and
electrically conductive formations 181, 182, 183 electrically coupling the die/chip 14 to the leads 12B.

As used herein the terms die/dice and chip/chips are regarded as synonymous.

Electrically conductive formations 181, 182, 183 as illustrated in Figure 1 may be provided via an LDS technique as described in the foregoing.

In the case exemplified in Figure 1 such a process may involve:
molding an LDS molding material/compound 20 (for instance, an epoxy resin having LDS additive particles embedded therein) on the substrate/leadframe 12 having a semiconductor die 14 mounted thereon,
laser structuring, that is, transferring a desired pattern to the LDS molding compound 20 via laser ablation, thus forming vias 181, 183 and traces 182,
plating metallic material (for instance, copper) to form an electrically conductive path coupling the lead 12B to the die pad 16 on the front/top surface of the semiconductor die 14, and
molding an insulating molding compound 22 (for instance, a standard, non-LDS, epoxy resin) to complete the protective plastic package of the device.

As mentioned, plating metallic material (metallization) may involve an electroless plating step (facilitated by the activated LDS particles in the molding compound 20) followed by electrolytic plating step.

Providing interconnects as illustrated in Figure 1 formed via LDS technique is per se conventional in the art and such interconnects are oftentimes referred to as direct copper interconnects (DCI), due to the extensive - but still, not mandatory - use of copper to form such interconnects with no use of (electrically conductive) wires that can reduce electrical performance and make the assembly flow more complex (involving, for example, a wire-bonding formation step).

It is thus desirable to provide interconnects via LDS technique to as many device/package classes or types as possible.

Conventional LDS technique as described in the foregoing may suffer from limitations such as, for instance:
laser ablation cannot drill "vertically" through the molding compound, and through-mold-vias (TMVs) are formed with a conical shape, and
in order to adequately plate such a conical TMV the diameter of the via at the base of the cone should be approximately equal to the depth of the via (1:1 aspect ratio).

Figures 2A and 2B show that in certain QFN packages through-mold-vias may extend deeply through the LDS molding compound and application of a (conventional) LDS technique to the case of deep TMVs may give rise to various issues.

For instance, Figure 2A illustrates a relatively thick (integrated circuit) semiconductor die 14 arranged on a substrate S and embedded in an encapsulation of LDS material 20.

If electrical coupling is desired to be provided between the die 14 (the die pad 16 on the front/top surface thereof) and the lead 12B, the relatively large thickness of the die 14 will cause the (through-mold) via 183 to extend in the LDS material for a depth T1 that, in certain cases, may be up to 600 microns.

As illustrated, application of a conventional LDS technique as described in the foregoing produces a via 183 having a diameter (indicated as D in the figure) at the front surface of the encapsulation approximately equal to the depth T1 of the via 183.

Forming a via 183 as illustrated in Figure 2A involves a time-consuming laser machining step due to the relatively large amount of LDS material that is ablated.

Furthermore, the large area occupied by the via 183 at the front surface of the encapsulation may pose design constraints to the packages.

Similar issues may arise in a device as illustrated in Figure 2B where two semiconductor dice 14A and 14B (for instance, an ASIC die 14B stacked on a sensor die 14A) are arranged in a stacked configuration having a total thickness that may be larger than 600 microns.

Solutions as described herein propose a time-effective method for forming electrically conductive through-mold-vias or interconnects via laser direct structuring, LDS.

Solutions as described herein may advantageously be applied to form interconnects in packages comprising thick or stacked dice.

In solutions as described herein, the thickness of the (LDS) molding compound that is drilled to form a via is reduced by removing a portion of molding compound, prior to laser drilling/ablation.

Solutions as described herein are compatible with concurrent processing of a plurality of semiconductor devices.

In the following, various embodiments of the present description will be described. The particular applications described are, however, merely exemplary in as much as the method described herein provides an improved and time-efficient way to provide through-mold-vias in an LDS molding compound/material. As those skilled in the art may appreciate, such a method may be applied in other cases than those discussed in the present description.

In current manufacturing processes of semiconductor devices, plural devices are manufactured concurrently to be separated into single individual device in a final singulation. For simplicity and ease of explanation, the following description will first refer to manufacturing a single device and the case of a plurality of semiconductor devices will be discussed in a later section.

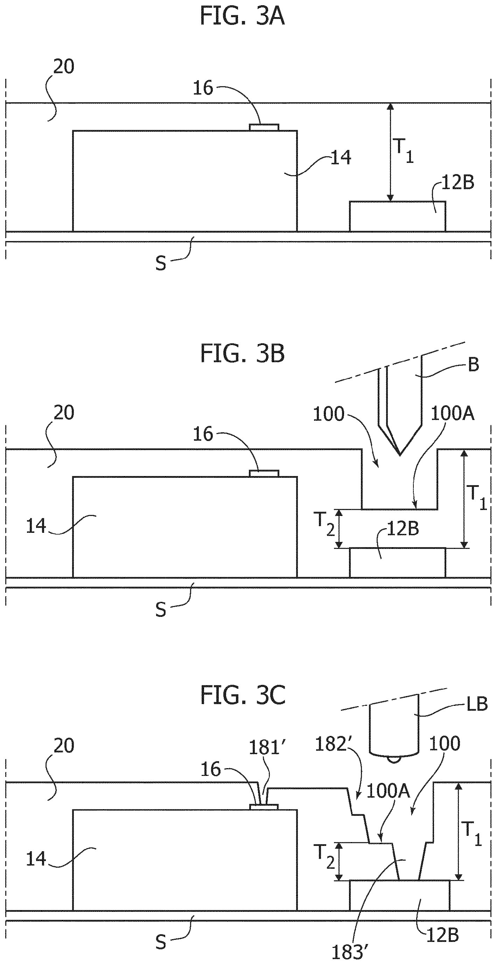

Figures 3A to 3E are illustrative of a method of manufacturing according to embodiments of the present description.

The sequence of steps of Figures 3A to 3E is merely exemplary insofar as one or more steps illustrated can be performed in a different manner (with other tools, for instance) and/or replaced by other steps and additional steps may be added.

Figure 3A is illustrative of a (IC) semiconductor die 14 having a relatively large thickness (for instance, larger than 600 microns) arranged on a substrate S.

The substrate S may be a tape or a carrier, for instance, that facilitates concurrent processing of a plurality of (IC) semiconductor devices.

According to various embodiments of the present description the substrate S may be a so-called leadframe and the semiconductor die 14 is arranged at a die mounting location (die pad) of the leadframe.

According to various embodiments of the present description the substrate S may be a sacrificial substrate, intended to be removed after processing.

In the case exemplified in Figure 3A, an electrically conductive path is to be formed between the die pad 16 provided on the top/front surface of the die 14 and the lead 12B.

Figure 3B is illustrative of LDS material 20 being removed at a location 100 above the lead 12B in order to reduce the thickness of the layer of LDS material on the lead 12B.

Cavities or trenches 100 as illustrated in Figure 3B may be formed via sawing, with a blade B, for instance, of the same type of the blade (or saw) used for singulation.

Partial cutting as illustrated in the figure is oftentimes referred to as "half-cutting": this is a common designation in the art, which does not imply that such partial cutting is by necessity to exactly half the total thickness of LDS molding material 20.

Partially removing the LDS material 20 results in a second surface 100A of the LDS material being exposed on the front/top of the assembly.

As illustrated in the figure, the thickness of the molding material 20 between the second surface 100A thereof and the lead 12B has been reduced.

Figure 3C is illustrative of a laser ablation (LB) step where laser beam energy is applied to the molding material 20 to form vias 183' towards the lead 12B. As illustrated vias 183' extend through the LDS material having a reduced thickness T2.

Vias 181' to the die pad 16 and traces 182' providing a path between vias 183' and 181' are provided via laser ablation/drilling as well.

It is noted that traces 182' extend from the top/front surface of the LDS material 20 and the second surface 100A of the LDS molding material exposed as a result of the formation of a trench 100.

Traces 182' may also comprise a portion extending in the trench/cavities 100, at a side wall thereof, as well as portion extending on the front/top surface of the encapsulation of LDS material 20.

Laser ablation as illustrated in Figure 3C activates the LDS molding compound, thus facilitating subsequent plating (copper plating, for instance).

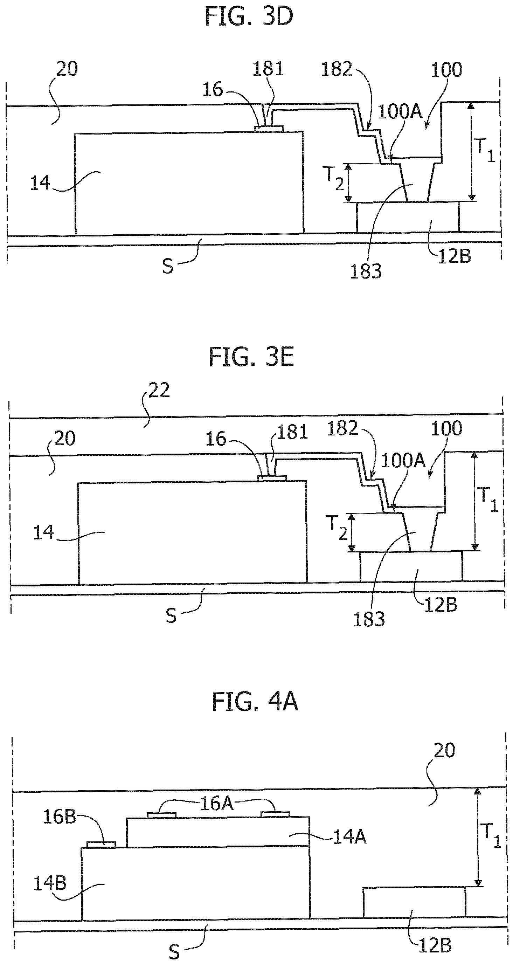

Figure 3D is illustrative of a metallization step where electrically conductive material (for instance, copper) is grown/deposited at vias 181', 183' and traces 182' formed and activated previously.

As mentioned, metallization may involve two plating steps:
an electroless plating step where the growth of a seed layer (of copper, for instance) in regions 181', 182' and 183' is facilitated by the LDS molding compound 20 being activated therein, and
an electrolytic plating step to grow further electrically conductive material on the seed layer deposited previously to form the electrically conductive path 181, 182, 183 (now referenced without an accent in order to highlight the fact that electrically conductive material has been grown therein).

As illustrated in Figure 3D, electrically conductive formations 181, 182 and 183 provide a conductive path between the die pads 16 on the front/top surface of the (IC) semiconductor die 14 and the lead 12B.

It is noted that metallization as illustrated occurs only in those regions (181', 182 and 183' in the case exemplified in the figures) where the LDS molding compound 20 has been (laser-)activated. Removing LDS material to form trenches 100 does not activate the LDS material and, as illustrated, no electrically conductive material is deposited on the side surfaces of the trench 100, for instance.

Figure 3E is illustrative of a second molding step where a molding compound 22 is molded onto the assembly illustrated in Figure 3D to complete the protective plastic package of the device (filling also the trench 100) .

The second molding compound may be a standard (that is, non-LDS) molding compound such as an epoxy resin, for instance.

A method according to embodiments of the present description may applied to the case of a "stacked" dice arrangement, as illustrated in the sequence of Figures 4A to 4D.

The sequence of Figures 4A to 4D is merely exemplary insofar as one or more steps can be performed in a different manner and/or replaced by other steps and/or additional steps may be added.

Figure 4A is illustrative of two integrated circuit semiconductor dice 14A and 14B are arranged in a "stacked" configuration on a substrate S.

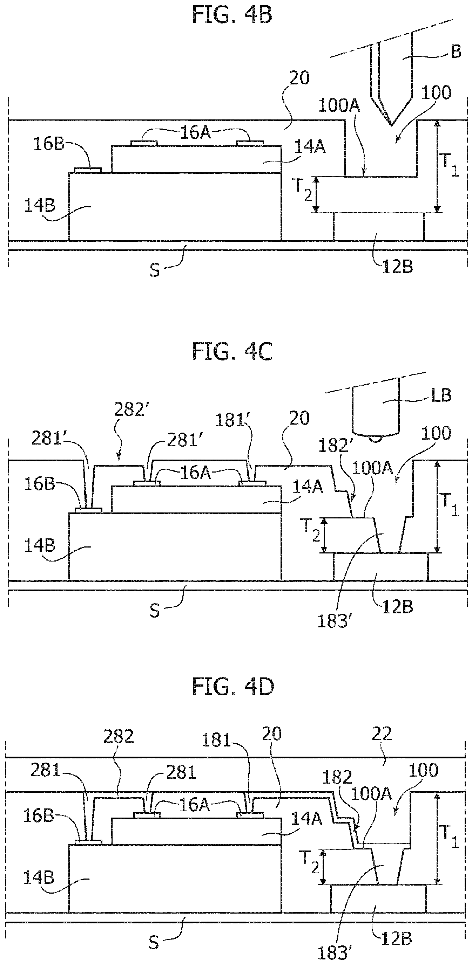

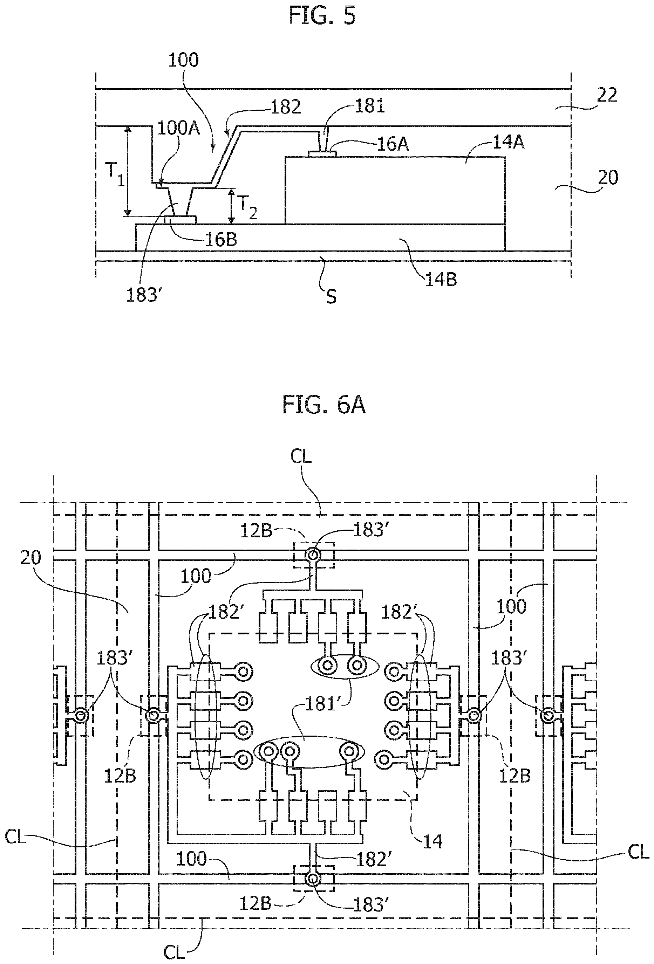

It is noted that in such a stacked arrangement as illustrated in Figure 4, the die 14B de facto acts as a support substrate for the die 14A. This is in contrast with a solution as illustrated in Figure 5 (discussed later) where the die 14B acts as a support substrate both for the die 14A and for the conductive formation 16A adjacent thereto.

The semiconductor dice 14A, 14B have respective die pads 16A, 16B on the front/top surface thereof.

The total thickness of the stacked dice 14A, 14B may in certain cases exceed 600 microns.

Figure 4B is illustrative of a trench 100 formed in the LDS compound 20 above the lead 12B, in order to reduce the amount of LDS molding compound 20 to be removed via laser ablation/drilling, similarly to the processing step illustrated in Figure 3B.

Figure 4C is illustrative of a laser ablation step (LB) to transfer a desired pattern to the LDS molding compound 20.

As illustrated, in addition to form vias 181', 183' and traces 182', additional "standard" vias 281', and traces 282' may be concurrently formed (via laser ablation/drilling) to provide a path between the die pads 16A and 16B.

The assembly may be processed in a similar way to what has been discussed in relation to Figures 3D and 3E, namely:
growing metallic material (via electroless plus electrolytic deposition, for instance) to from first electrically conductive formations 181, 182,182 between the semiconductor die 14A and the lead 12B and second electrically conductive formations 281, 282 between the first and second semiconductor die 14A,14B, and
molding a molding compound 22 - possibly, a non-LDS compound - to complete the protective plastic package of the device.

As mentioned, the method described herein is not limited to formation of vias towards a lead 12B as discussed in the foregoing, but it can be applied to form vias to electrically conductive formations in general.

For instance, the method described herein may be advantageously applied in a stacked dice arrangement as exemplified in Figure 5.

In certain cases, it is desirable to provide electrical coupling between a first semiconductor die 14A (600 microns thick, for instance) arranged on a second die 14B in a stacked dice configuration.

As illustrated in Figure 5 a cavity/trench 100 may be formed (via sawing, for instance) above the second semiconductor die 14B, more precisely above a die pad 16B thereof, in order to reduce the thickness (T2<T1) of the LDS compound 20 to be ablated/drilled to reach the die pad 16B.

Processing to obtain a device as illustrated in Figure 5 may be performed in a similar way to the case discussed previously and a detailed description of the processing steps is not repeated for brevity.

It is noted that, in the example illustrated in Figure 5, the second semiconductor chip 14B acts as substrate to both the first semiconductor chip 14A and the electrically conductive formation, that is, the die pad 16B, arranged thereon.

The method described herein may advantageously be applied in cases other than those presented in the foregoing, as it provides an advantageous way to provide electrical coupling to a component (such a lead 12B or a die 14B, for instance) via LDS technique.

More generally, a method as described herein may be summarized as follows.

LDS material 20 is molded onto a semiconductor die/chip 14 (or 14A) arranged on a substrate S (or 14B) with a first (front) surface facing away from the substrate.

At least one electrically conductive formation 12B/16B is arranged on the substrate S/14B, adjacent to semiconductor chip 14/14A.

The LDS material 20 has a first thickness T1 between a front surface of the LDS material 20) and the substrate S/14B.

Laser beam energy LB is applied to the LDS material 20 in order to laser structure therein at least one via 183' towards the electrically conductive formation 12B/16B.

The first surface of the semiconductor chip 14/14A and the electrically conductive formation 12B/16B are electrically coupled (via the conductive path formed by 181, 182, 183) with electrically conductive material (for instance, copper) in the at least one via 183' laser structured in the LDS material 20.

Unstructured LDS material is removed (for instance, via sawing B) from the front surface of the LDS material 20 to form therein a cavity (or trench) 100 having an end wall 100A between the front surface of the LDS material 20 and the electrically conductive formation 12B/16B, so that the LDS material at the cavity 100 has a second thickness T2 smaller than the first thickness T2<T1.

Laser beam energy LB is applied to the LDS material 20 at the end wall 100A of the cavity/trench 100 to laser structure therein the via 183' that extends between the end wall 100A of the cavity 100 and the conductive formation 12B/16B.

Laser beam energy LB may also be applied to laser structure the LDS material 20 at a side wall of the cavity 100 adjacent the semiconductor chip 14/14A with electrically conductive material 182 grown on LDS material 20 laser-structured at the side wall of the cavity 100, thus forming.

The LDS material 20 may be laser structured also to form one further via 181' towards the first surface of the semiconductor chip 14/14A.

The method of manufacturing described so far may also be applied to the case where a plurality of integrated circuit semiconductor devices is processed concurrently.

Concurrent processing may be done by arranging a plurality of semiconductor dice on a carrier such as a tape, a panel or a wafer carrier; as those skilled in the art may appreciate, the method described herein may be applied irrespective of the particular shape of the carrier.

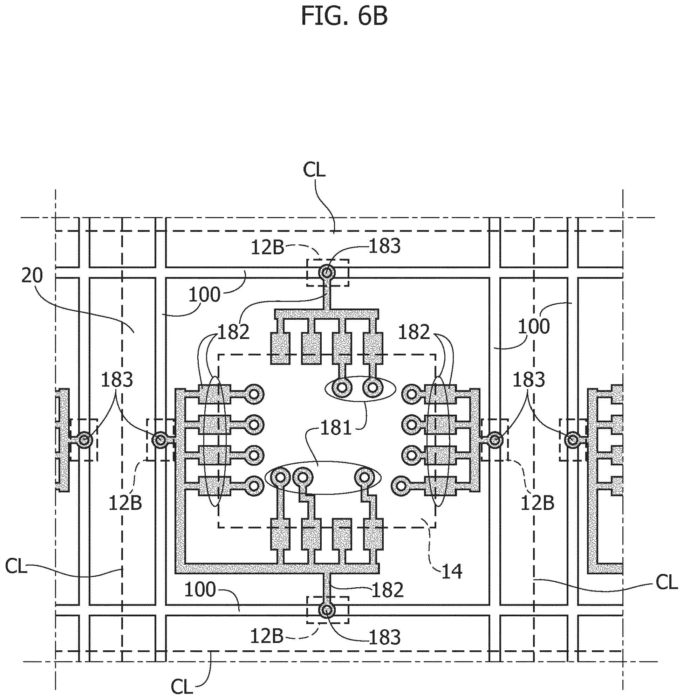

Figures 6A and 6B are plan views illustrative of a portion of a carrier (tape, panel or wafer, for instance) having a plurality of semiconductor dice 14 arranged thereon.

As illustrated, LDS molding compound 20 is molded onto the plurality of semiconductor dice 14 arranged on the carrier.

In the case exemplified in Figure 5 an individual device is provided with four leads 12B arranged at the periphery of the device (that is, in the vicinity of the dashed line CL that indicates the line along which final singulation cut will be performed).

Trenches 100 are formed in the LDS compound 20 running at the periphery of the devices and passing over the leads 12B. As illustrated trenches 100 may be formed extending throughout the length and the width of the panel (or tap or wafer), thus reducing the thickness of the LDS molding compound 20 above the leads 12B of a plurality of semiconductor device with a single (half-) cut.

Vias 181' to the die pads (not visible for simplicity), vias 183' to the leads 12B and traces 182' with a desired pattern are formed via laser ablation.

As illustrated, vias 183' are laser drilled at trenches 100 through the LDS compound 20 layer with reduced thickness.

Figure 6B illustrates electrically conductive formations 181, 182, 183 grown at the locations activated by the laser 181', 182' and 183', thus providing the desired electrical couplings.

Further processing steps may comprise:
a second molding step, possibly with a non-LDS compound, and
a singulation step where the panel is cut into individual devices by cutting/sawing (full cut) along the cutting lines CL with a blade, for instance.

Without prejudice to the underlying principles, the details and embodiments may vary, even significantly, with respect to what has been described by way of example only without departing from the extent of protection.

The extent of protection is determined by the annexed claims.

## Claims

1. A method, comprising:
molding laser direct structuring, LDS material (20) onto a semiconductor chip (14; 14A) arranged on a substrate (S; 14B) with a first surface facing away from the substrate (S; 14B) and at least one adjacent electrically conductive formation (12B; 16B) arranged on the substrate (S; 14B), wherein the LDS material (20) has a first thickness (T1) between a front surface of the LDS material (20) and the substrate (S; 14B),
applying laser beam energy (LB) to the LDS material (20) to laser structure therein at least one via (183') towards the at least one electrically conductive formation (12B; 16B), and
electrically coupling (181, 182, 183) the first surface of the semiconductor chip (14; 14A) and the at least one electrically conductive formation (12B; 16B) with electrically conductive material in said at least one via (183') laser structured in the LDS material (20),
wherein the method comprises:
removing (B) unstructured LDS material from the front surface of the LDS material (20) to form therein a cavity (100) having an end wall (100A) between the front surface of the LDS material (20) and the at least one electrically conductive formation (12B; 16B), the LDS material having at the cavity (100) a second thickness (T2) smaller than said first thickness (T1), and
applying laser beam energy (LB) to the LDS material (20) at the end wall (100A) of said cavity (100) to laser structure therein said at least one via (183'), wherein said at least one via (183') extends between the end wall (100A) of said cavity (100) and the at least one electrically conductive formation (12B; 16B).

2. The method of claim 1, comprising applying laser beam energy (LB) to laser structure the LDS material (20) at a side wall of said cavity (100) adjacent the semiconductor chip (14; 14A) with electrically conductive material (182) grown on LDS material (20) laser-structured at said side wall of said cavity (100).

3. The method of claim 2, comprising applying laser beam energy (LB) to the LDS material (20) to laser structure therein at least one further via (181') towards the first surface of the semiconductor chip (14; 14A), wherein said electrically coupling (181, 182, 183) is with electrically conductive material in:
said at least one via (183') extending between the end wall (100A) of said cavity (100) and said at least one electrically conductive formation (12B; 16B);
said LDS material (20) laser-structured at said side wall of said cavity (100); and
said at least one further via (181') towards the first surface of the semiconductor chip (14; 14A).

4. The method of any of the previous claims, comprising molding the laser direct structuring, LDS material (20) onto a stacked arrangement of semiconductor chips (14A, 14B) comprising a first semiconductor chip (14A) having said first surface, and a second semiconductor chip (14B) having said first semiconductor chip (14A) arranged thereon.

5. The method of claim 4, wherein said second semiconductor chip (14B) provides said substrate (14B) having the first semiconductor chip (14A) and, preferably, said at least one electrically conductive formation (16B) arranged thereon.

6. The method of any of claims 1 to 4, wherein the substrate comprises a sacrificial substrate (S).

7. The method of any of the previous claims, wherein:
the method comprises removing (B) unstructured LDS material from the front surface of the LDS material (20) to form therein a cavity (100) of substantially uniform cross-section from the front surface of the LDS material (20) to said end wall (100A), and/or
said cavity (100) comprises a trench at the front surface of the LDS material (20) having an elongated end wall (100A) and the method comprises applying laser beam energy (LB) to the LDS material (20) at a plurality of locations of said elongated end wall (100A) to laser structure therein a plurality of vias (183') extending between the end wall (100A) of said cavity (100) and respective electrically conductive formations (12B; 16B), and/or
the method comprises molding encapsulation material (22) into said cavity (100) having laser beam energy (LB) applied to the LDS material (20) at the end wall (100A) of said cavity (100) to laser structure therein said at least one via (183').

8. A device (10), comprising:
laser direct structuring, LDS material (20) molded onto a semiconductor chip (14; 14A) and at least one electrically conductive formation (12B; 16B) arranged adjacent the semiconductor chip (14; 14A), wherein the LDS material (20) has a first thickness (T1),
at least one via (183') laser-structured in the LDS material (20) towards the at least one electrically conductive formation (12B; 16B),
wherein a first surface of the semiconductor chip (14; 14A) and the at least one electrically conductive formation (12B; 16B) are electrically coupled (181, 182, 183) with electrically conductive material in said at least one via (183') laser-structured in the LDS material (20),
wherein the device comprises:
a cavity (100) provided by unstructured LDS material removed from a front surface of the LDS material (20), the cavity (100) having an end wall (100A) between the front surface of the LDS material (20) and the at least one electrically conductive formation (12B; 16B), the LDS material having at the cavity (100) a second thickness (T2) smaller than said first thickness (T1), and
said at least one via (183') laser-structured in the LDS material (20) at the end wall (100A) of said cavity (100), wherein said at least one via (183') extends between the end wall (100A) of said cavity (100) and the at least one electrically conductive formation (12B; 16B).

9. The device of claim 8, comprising laser-structured LDS material (20) at a side wall of said cavity (100) adjacent the semiconductor chip (14; 14A) with electrically conductive material (182) grown on LDS material (20) laser-structured at said side wall of said cavity (100).

10. The device of claim 9, comprising at least one further via (181') laser-structured in the LDS material (20) towards the first surface of the semiconductor chip (14; 14A), wherein the first surface of the semiconductor chip (14; 14A) and the at least one electrically conductive formation (12B; 16B) are electrically coupled with electrically conductive material in:
said at least one via (183') extending between the end wall (100A) of said cavity (100) and said at least one electrically conductive formation (12B; 16B);
said LDS material (20) laser-structured at said side wall of said cavity (100); and
said at least one further via (181') towards the first surface of the semiconductor chip (14; 14A).

11. The device of any of claims 8 to 10, comprising laser direct structuring, LDS material (20) molded onto a stacked arrangement of semiconductor chips (14A, 14B) comprising a first semiconductor chip (14A) having said first surface, and a second semiconductor chip (14B) having said first semiconductor chip (14A) arranged thereon.

12. The device of claim 11, wherein said second semiconductor chip (14B) provides a substrate (14B) having the first semiconductor chip (14A) and said at least one electrically conductive formation (16B) arranged thereon.

13. The device of any of claims 8 to 10, wherein:
said cavity (100) has a substantially uniform cross-section from the front surface of the LDS material (20) to said end wall (100A), and/or
said cavity (100) comprises a trench at the front surface of the LDS material (20) having an elongated end wall (100A) with a plurality of vias (183') laser-structured in the LDS material (20) the plurality of vias (183') extending between the end wall (100A) of said cavity (100) and respective electrically conductive formations (12B; 16B), and/or
the device comprises encapsulation material (22) molded into said cavity (100) having said at least one via (183') laser-structured in the LDS material (20) at the end wall (100A) of said cavity (100).
